# EUROPEAN PATENT SPECIFICATION

(11) **EP 0 720 260 B1**
(45) Date of publication and mention of the grant of the patent: **14.02.2001**
(21) Application number: 95119163.4
(22) Date of filing: 06.12.1995
(51) Int. Cl.: H01S 5/02, H01S 3/00, H01L 33/00, H01L 23/26

(54) **Getter housing for optoelectronic packages**
Gettergehäuse für eine optoelektronische Packung
Boîtier à getter pour des assemblages optoélectroniques

(30) Priority: 27.12.1994 US 364264
(43) Date of publication of application: 03.07.1996
(73) Proprietor: CORNING INCORPORATED, Corning, N.Y. 14831 (US)
(72) Inventor: DeMeritt, Jefferey A., Corning, NY 14831 (US); Martinez, Carlos M., Corning, NY 14831 (US)
(74) Representative: Marchant, James Ian

(56) References cited:
- EP-A- 0 634 822
- DE-A- 3 511 323
- US-A- 4 740 985
- PATENT ABSTRACTS OF JAPAN vol. 009 no. 118 (E-316) ,23 May 1985 & JP-A-60 007739 (NIPPON DENKI KK) 16 January 1985,
- PATENT ABSTRACTS OF JAPAN vol. 018 no. 174 (E-1530) ,24 March 1994 & JP-A-05 343812 (KUBOTA CORP) 24 December 1993,
- PATENT ABSTRACTS OF JAPAN vol. 010 no. 027 (E-378) ,4 February 1986 & JP-A-60 186076 (NIPPON DENSHIN DENWA KOSHA;OTHERS: 01) 21 September 1985,

## Description

### Background

This invention relates to containers for optoelectronic packages and more particularly, to getter housings for containers.

While the present invention relates generally to optoelectronic packages, it is described herein in connection with high power semiconductor lasers.

Semiconductor laser technology has matured to produce devices which are suitable for applications requiring long term, reliable laser operation. Strategies for maintaining laser stability and prolonging laser life include control of the laser operating environment. It had been previously thought that the atmosphere for such prior art laser housings should be relatively inert with respect to the semiconductor laser materials, and in particular, that an atmosphere free of oxygen would extend laser life. Also a dry atmosphere was preferred to prevent reaction with the laser materials and to preserve the integrity of the miniature electric circuitry associated with the laser operation. The introduction of optical amplifiers into telecommunications systems has led to the use of high power pump lasers. Furthermore the demand for high data rate systems with long repeater spacing has resulted in the use of high power signal lasers. In the diodes used in such applications, semiconductor laser facet power has increased to 50 mW and higher. In such devices, the previously accepted strategies for stable, long term laser operation have proved to be inadequate.

A possible mechanism for shortened laser life in the standard package is accumulation of solid or liquid material on intensely illuminated surfaces, such as the laser front facet, lenses in the laser beam or the fiber lenses and windows. The surface accumulation may occur as follows. Mobile hydrocarbons from solder flux residue, cleaning solvents, contaminants in the assembly environment, or the like are present in the hermetically sealed laser container. A photo-reaction may occur when a hydrocarbon encounters the laser photon flux. The products of the photo-reaction may form a deposit on the intensely illuminated surfaces. Laser performance is degraded when these deposits inordinately reflect or absorb the laser light. If the deposits absorb photons, heat build up can occur, causing melting of an active or passive surface. The heat buildup may cause accelerated diffusion of dopants at or near the laser diode junction thereby destroying the junction or reducing the junction efficiency.

Although oxygen in the sealed atmosphere of the package may lengthen laser life, by action of the oxygen combining with a hydrocarbon contaminant or the products of a photo-reacted hydrocarbon to prevent or remove accumulations on passive or active components in the laser enclosure, oxygen in the enclosure can form water when combined with hydrogen present in the enclosure atmosphere. The hydrogen may be present as a contaminant in the gas filling the enclosure or may outgas from the metal walls of the enclosure as temperature of the enclosure increases. It is known that water causes electrical shorts, corrosion or electro-migration in the electrical circuits present in the enclosure.

During the manufacture of optoelectronic packages, steps are taken to minimize the amount of organic material within the enclosed container. For example, a suitable cleaning agent such as isopropyl alcohol can be used to remove residues of the manufacturing process, such as solder flux.

It was previously thought that the getter material should be used in block form to facilitate its incorporation in the laser enclosure. Mechanical mounting means were preferred rather than organic materials, e.g., epoxies or glues. For example, wire or spring clip or screw mounting was considered suitable, as well as mechanical solder attachment wherein, for example, through-holes are formed in the block of getter material, the getter being placed on the inside surface of the enclosure's cover, and the getter being soldered to the cover by pouring molten solder through the through-holes.

Getter materials, especially glass and glass ceramic getter materials, are subject to particulate shedding. This could cause failure of components within a shared package, e.g. by shorting of closely spaced electrical paths or by more direct damage to optoelectronic components, such as the intrusion of an absorbing particle into the emitting path of a laser diode. Protective packaging is required to reduce the likelihood of getter particulate shedding and/or to reduce the likelihood of device failure in the event that such shedding does occur.

Patent Abstracts of Japan, vol. 018, no.174 (E-1530), March 1994 discloses an optoelectronic package according to the preamble of claim 1.

An object of the invention is to prevent damage to optoelectronic devices such as semiconductor lasers caused by the particulate shedding of getter material. Another object is to provide an improved technique for retaining getter material within optoelectronic packages.

The invention is defined in claim 1. Various embodiments are defined in the dependent claims.

The permeable surface of the getter housing can be formed of porous metal or sheet metal having apertures therein. The getter housing optionally contains a spring for retaining the getter.

In one embodiment, the getter is effective for adsorbing or absorbing mobile hydrocarbons and water.

### Brief Description of the Drawings

Fig. 1 is a cross-sectional view of a laser enclosure incorporating a getter.

Fig. 2 is an exploded side view showing typical components of a high power laser.

Fig. 3 is a cross-sectional view of a porous metal getter housing.

Fig. 4 is a cross-sectional view taken along lines 4-4 of Fig. 3.

Fig. 5 is a cross-sectional view of a further getter housing.

Fig. 6 is an exploded view showing a modification of Fig. 5.

Fig. 7 is a cross-sectional view of a laser enclosure incorporating yet another getter housing.

### Detailed Description of the Invention

The getter housing of the present invention is described in connection with high power laser packaging. However, this getter package is also applicable to various other kinds of optoelectronic packaging.

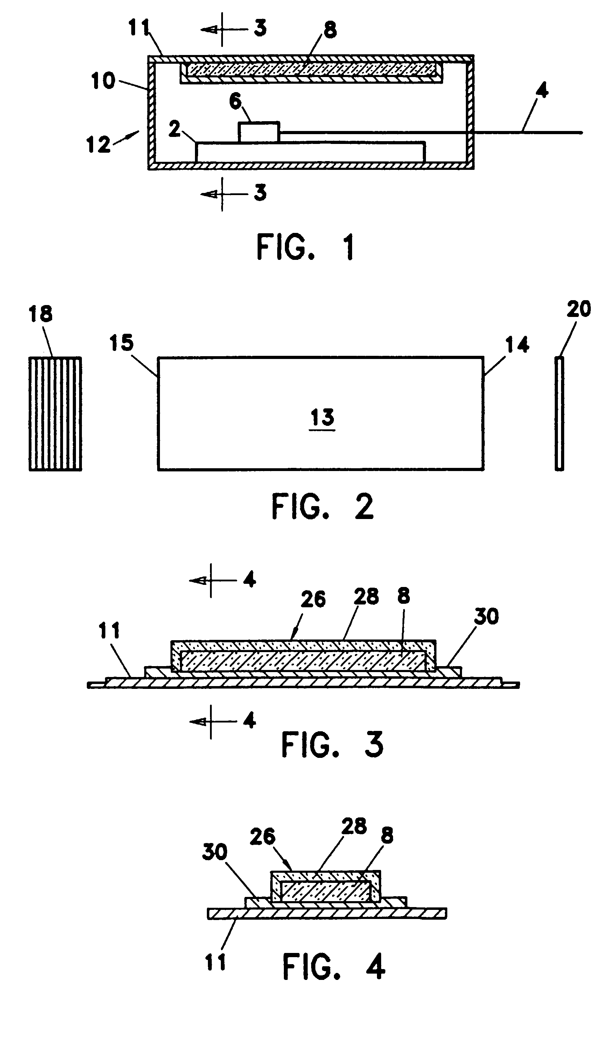

FIG. 1 shows a hermetically sealed, high power laser package or enclosure 12 including a housing 10 and cover 11. The high power laser 6 is fixed to substrate 2. The electronic devices and circuitry which are associated with the laser and typically contained in the enclosure are not shown. The means for coupling the laser light to a receiving device or to an optical fiber is shown as optical fiber 4. Other coupling means such as lenses or integrated waveguide devices may be employed as couplers. The laser light may be coupled to a receiving device or a waveguide located within the enclosure. As an alternative, the coupling means may allow the laser light to pass out of the enclosure through a sealed aperture.

FIG. 2 is an illustration of the parts of a high power laser. The lasing body 13 is shown as having front and rear facets 14 and 15. The front and back facet partially reflective mirrors 20 and 18, respectively, support the lasing action. Possible mechanisms for the failure of the laser are discussed above. Briefly, photo-reactions, which may cause deposits on mirror 20 or other optical components within the enclosure, take place in the flux path beginning at mirror 20.

The laser container is filled with a gaseous medium whose oxygen content is greater than 100 ppm. The oxygen within the packaging atmosphere minimizes laser damage by organic impurities. However, the oxygen can react with hydrogen to form within the laser enclosure water which can adversely affect the overall operation of the electronic components within the enclosure.

The water problem can be partially addressed by reducing the amount of hydrogen available within the enclosure for reaction with the oxygen of the oxygen-containing atmosphere. The metals used to form the walls of the container are pretreated; specifically, they are baked at an elevated temperature and for an extended period of time in order to substantially reduce the amount of hydrogen adsorbed or absorbed therein.

To further address the water problem, enclosure 10 is provided with a getter 8 which acts to immobilize pre-selected type and size molecules. The getter is shown as a thin slab attached to the top inside surface of cover 11. Because of the typically small inside volume of the enclosure, a single getter body attached to an inside surface should be effective to immobilize the water and organic impurities which may be present.

Getter materials must have sufficient porosity to provide them with surface area that is sufficiently great that small pieces thereof can be used to adsorb or absorb useful quantities of undesired molecules within a hermetically sealed container. Thus, such materials, especially glass and glass ceramic getter materials, are fragile and subject to particulate shedding. The housing of the present invention is adapted to prevent damage to components and/or prevent obstruction of light paths in the event that particulate shedding occurs.

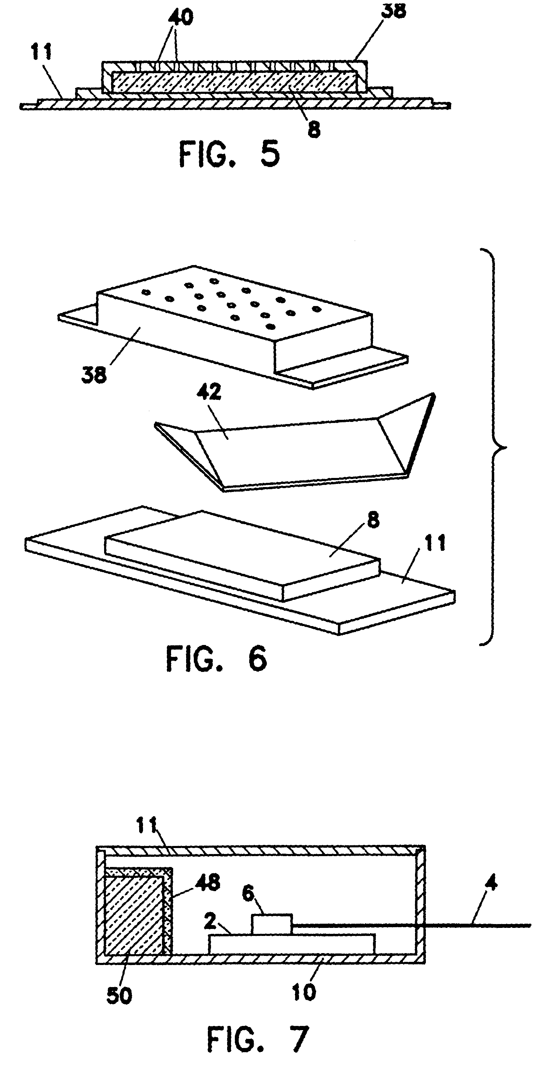

A preferred getter housing 26 is shown in Figs. 3 and 4. The housing consists of a porous metal container 28 that can be formed by pressing or electro-discharge machining. Container 28 can be affixed to intermediate plate 30 which can be attached to the inner surface of cover 11. Alternatively, container 28 can be affixed directly to the cover. The entire periphery of container 28 is preferably welded to plate 30 so that there are no gaps through which particles of getter material could pass. Any seams, such as those that occur where two sides converge to form a corner, should also be attached by welding, soldering or the like. Cover 11 is then affixed to housing 10. The resultant package 12 protects the laser and electronics from particles that might shed or flake from getter 8, thereby reducing the likelihood of device failure.

When a porous metal container is employed, the getter need not be in the form of a pellet or slab. Rather, it could be in powder or granular form, since the porous metal would prevent even powder from escaping from the getter container to the device within enclosed container 12.

In the embodiment of Fig. 5, the getter housing consists of a sheet metal container 38 having a plurality of apertures 40 therethrough. Apertures 40 could be formed by water jet machining, laser machining, or the like. Smaller apertures are obviously preferred since they are more effective in protecting the devices within container 12 from getter particles.

A modification of the embodiment of Fig. 5 is shown in Fig. 6. Getter 8 is positioned on cover 11. A sheet metal spring 42 is placed on getter 8. After housing 38 has been placed over the spring and getter and is welded to cover 11, the ends of the spring contact housing 38 and secure getter 8 to cover 11. This construction prevents the getter from shifting within the container when the package is moved or vibrated.

Getter containers may be fixedly attached to any or all of the inside surfaces of the enclosure. Fig. 7 shows a getter container comprising a bent porous metal sheet 48 that is affixed to the bottom, end and two side walls of housing 10.

A laser and other components for using the laser to provide power to an optical fiber in a fiber amplifier are packaged along with a getter in a low-hydrogen Kovar container filled with an oxygen-containing atmosphere as follows.

The container for the laser is fabricated from Kovar plated with gold and nickel in two sections -- a body section for holding the laser and other components and a cover for carrying the getter. The two sections are baked in a N₂ purged oven at 150°C for 200 hours. The internal volume of the container is approximately 5 cm³.

The getter was formed as follows. A batch of 35 weight percent zeolite ZSM-5, 35 weight percent zeolite 4A, and about 20 weight percent porous Vycor™ brand glass was dry mixed. Nineteen weight percent of Dow Corning silicone resin Q6-2230 was added and dry mixed into the batch. This amount was sufficient to yield about 10 weight percent silica in the finished getter. Dow Corning methyl cellulose at about 6 weight percent super-addition was also dry mixed into the batch. The base weight percent is taken as the combined weight of the zeolites, the porous Vycor™ brand glass and the silica. A super-addition weight percent is calculated on the base weight but is not included in the base weight for weight percent calculations. An organic solvent, either isopropyl alcohol or Dupont dibasic ester, and water were added to the dry mixture to produce an extrudable batch consistency. The plasticized batch was extruded into flat sheets, having a thickness no greater than 1 mm. The green body sheets were dried in air at about 85°C to 100°C for at least 3 days. Tablets were cut from these sheets with allowance for shrinkage to form finished pieces 3mm x 9mm x 1 mm after calcining at 500-620°C for a minimum of 10 hours. One of the tablets of getter material is enclosed in a housing formed of porous metal as described in conjunction with Figs. 3 and 4. This assembly is fastened to the inner surface of the laser package cover.

The semiconductor laser and other components are mounted in the housing section of the package. That section along with the cover section with its attached getter are then baked for 4 hours at 300°C. Finally, the two sections are sealed together in an atmosphere of the 00.1 air product referred to above. The sealing is performed by fluxless, electrical-resistance heating.

In similar packages, the semiconductor laser has been found to operate successfully over an extended period of time, i.e., for over 5000 hours, with minimal free water in the package, i.e., a water concentration in the package atmosphere of less than 5000 ppm at the end of the test period. The packaged high power semiconductor laser is thus suitable for use in providing power to an amplifier fiber in a fiber optic system.

## Claims

1. An optoelectronic package (12) comprising a hermetically sealed enclosure (10) having an optoelectronic device disposed therein, the enclosure having further disposed in it a getter (8) capable of removing from the atmosphere an impurity whose presence adversely affects the optoelectronic device, characterised in that the enclosure has an atmosphere whose oxygen content is greater than 100 ppm and the getter is enclosed in a getter housing (26) completely sealing the getter from the device except that the housing has at least one surface which is permeable to the impurity but resists the passage of particles of the getter into the enclosure.

2. An optoelectronic package as claimed in claim 1 wherein the optoelectronic device is a semiconductor laser.

3. An optoelectronic package as claimed in claim 1 or 2 wherein at least a portion of the getter housing is formed of porous metal.

4. An optoelectronic package as claimed in claim 1 or 2 wherein at least a portion of the getter housing is formed of sheet material having apertures therein.

5. An optoelectronic package as claimed in any of claims 1 to 4 wherein the enclosure includes a cover (11) and the getter housing is affixed to the cover.

6. An optoelectronic package as claimed in any of claims 1 to 5 wherein the getter housing contains a spring for retaining the getter.

7. An optoelectronic package as claimed in any of claims 1 to 6 wherein the getter is in the form of a thin slab.

8. An optoelectronic package as claimed in any of claims 1 to 7 wherein the getter is formed of a porous material that tends to flake when subjected to physical agitation.

9. An optoelectronic package as claimed in any of claims 1 to 6 wherein the getter is in powdered form.

10. An optoelectronic package as claimed in any of claims 1 to 9 wherein the getter is effective for adsorbing or absorbing mobile hydrocarbons and water.

## Patentansprüche

1. Eine optoelektronische Gehäuseeinheit (12), die aus einem hermetisch verschlossenen Gehäuse (10) besteht, in der eine optoelektronische Anordnung untergebracht ist, wobei das Gehäuse ferner über einen Getter (8) verfügt, der in der Lage ist, aus einer Atmosphäre eine Verunreinigung zu entfernen, deren Anwesenheit umgekehrt die optoelektronische Anordnung ungünstig beeinflusst, die dadurch gekennzeichnet ist, dass das Gehäuse eine Atmosphäre besitzt, deren Sauerstoffgehalt größer als 100 ppm ist und dass der Getter in einem Gettergehäuse (26) eingeschlossen ist, das den Getter komplett von der Anordnung verschließt mit der Ausnahme, dass das Gehäuse wenigstens eine Oberfläche hat, die für die Verunreinigung durchlässig ist aber den Durchlass von Partikeln des Getters in das Gehäuse verhindert.

2. Eine optoeelektronische Gehäuseeinheit nach Anspruch 1, wobei die optoelektronische Anordnung ein Halbleiterlaser ist.

3. Eine optoelektronische Gehäuseeinheit nach Anspruch 1 oder 2, wobei wenigstens ein Teil des Gettergehäuses durch ein poröses Metall geformt wird.

4. Eine optoelektronische Gehäuseeinheit nach Anspruch 1 oder 2, wobei wenigstens ein Teil des Gettergehäuses aus einer dünnen Materialplatte besteht, die darin Öffnungen hat.

5. Eine optoelektronische Gehäuseeinheit nach irgendeinem der Ansprüche 1 bis 4, wobei das Gehäuse einen Deckel (11) beinhaltet und das Getter-Gehäuse am Deckel befestigt ist.

6. Eine optoelektronische Gehäuseeinheit nach irgendeinem der Ansprüche 1 bis 5, wobei das Gettergehäuse eine Feder zum Festhalten des Getters hat.

7. Eine optoelektronische Gehäuseeinheit nach irgendeinem der Ansprüche 1 bis 6, wobei der Getter die Form einer dünnen Platte hat.

8. Eine optoelektronische Gehäuseeinheit nach irgendeinem der Ansprüche 1 bis 7, wobei der Getter aus porösem Material geformt ist, das dazu neigt, abzublättern, wenn es physikalischer Beanspruchung ausgesetzt wird.

9. Eine optoelektronische Gehäuseeinheit nach irgendeinem der Ansprüche 1 bis 6, wobei der Getter in pulvriger Form vorliegt.

10. Eine optoelektronische Gehäuseeinheit nach irgendeinem der Ansprüche 1 bis 9, wobei der Getter in der Lage ist, Hydrocarbone und Wasser zu adsorbieren oder absorbieren.

## Revendications

1. Conditionnement optoélectronique (12) comprenant une enceinte scellée hermétiquement (10) comportant un dispositif optoélectronique disposé dans celle-ci, l'enceinte comportant en outre, disposé dans celle-ci, un getter (8) capable d'éliminer de l'atmosphère une impureté dont la présence affecte de façon néfaste le dispositif optoélectronique, caractérisé en ce que l'enceinte présente une atmosphère dont la teneur en oxygène est supérieure à 100 ppm et le getter est enfermé dans un logement de getter (26) rendant complètement étanche le getter par rapport au dispositif à l'exception de ce que le logement comporte au moins une surface qui est perméable à l'impureté mais résiste au passage des particules du dégazeur dans l'enceinte.

2. Conditionnement optoélectronique selon la revendication 1, dans lequel le dispositif optoélectronique est un laser à semiconducteur.

3. Conditionnement optoélectronique selon la revendication 1 ou 2, dans lequel au moins une partie du logement de getter est formée de métal poreux.

4. Conditionnement optoélectronique selon la revendication 1 ou 2, dans lequel au moins une partie du logement de getter est formée d'un matériau en feuille comportant des ouvertures dans celui-ci.

5. Conditionnement optoélectronique selon l'une quelconque des revendications 1 à 4, dans lequel l'enceinte comprend un couvercle (11) et le logement du getter est fixé au couvercle.

6. Conditionnement optoélectronique selon l'une quelconque des revendications 1 à 5, dans lequel le logement du getter contient un ressort destiné à retenir le dégazeur.

7. Conditionnement optoélectronique selon l'une quelconque des revendications 1 à 6, dans lequel le getter est sous forme d'une mince tablette.

8. Conditionnement optoélectronique selon l'une quelconque des revendications 1 à 7, dans lequel le getter est formé d'un matériau poreux qui tend à s'écailler lorsqu'il est soumis à une agitation physique.

9. Conditionnement optoélectronique selon l'une quelconque des revendications 1 à 6, dans lequel le getter est sous une forme de poudre.

10. Conditionnement optoélectronique selon l'une quelconque des revendications 1 à 9, dans lequel le getter est efficace pour adsorber et pour absorber des hydrocarbures mobiles et de l'eau.
